# EUROPEAN PATENT APPLICATION

(11) **EP 4 715 596 A1**
(43) Date of publication of application: **25.03.2026**
(21) Application number: 24830018.8
(22) Date of filing: 27.03.2024
(51) Int. Cl.: G06F 11/07

(54) **MEMORY FAULT PROCESSING METHOD, APPARATUS, ELECTRONIC DEVICE AND READABLE STORAGE MEDIUM**

(30) Priority: 26.06.2023 CN 202310763323
(71) Applicant: Huawei Technologies Co., Ltd., Shenzhen, Guangdong 518129 (CN)
(72) Inventor: LIN, Feilong, Shenzhen, Guangdong 518129 (CN); YANG, Kunlin, Shenzhen, Guangdong 518129 (CN)
(74) Representative: Pfenning, Meinig & Partner mbB
(86) International application number: PCT/CN2024/084193
(87) International publication number: WO 2025/001366

(57) **Abstract**

This application provides a memory fault processing method and apparatus, an electronic device, and a readable storage medium. In the method, a faulty first storage cell is determined (S801), the first storage cell is isolated (S802), a pressure test is performed on the first storage cell to obtain a fault level of the first storage cell (S803), and a corresponding operation is performed on the first storage cell based on the fault level of the first storage cell, where when the fault level of the first storage cell indicates that the first storage cell is at a first risk level, the operation performed on the first storage cell includes de-isolating the first storage cell (S804). In this application, after a faulty storage cell is isolated, a pressure test may be further performed on the storage cell to obtain a real fault level of the storage cell. When the fault level of the first storage cell is the first risk level, the electronic device may de-isolate the first storage cell, and the first storage cell may continue to be used. In this application, a quantity of available storage cells may be increased.

## Description

This application claims priority to Chinese Patent Application No. 202310763323.5, filed with the China National Intellectual Property Administration on June 26, 2023 and entitled "MEMORY FAULT PROCESSING METHOD AND APPARATUS, ELECTRONIC DEVICE, AND READABLE STORAGE MEDIUM", which is incorporated herein by reference in its entirety.

### TECHNICAL FIELD

Embodiments of this application relate to the field of storage technologies, and in particular, to a memory fault processing method and apparatus, an electronic device, and a readable storage medium.

### BACKGROUND

Memory (memory) is an important component of an electronic device, and is configured to temporarily store operation data of a processor in the electronic device, data exchanged with the external such as a hard disk, and the like. The electronic device may include a memory controller. The memory controller is configured to manage the memory and is responsible for data exchange between the memory and the processor.

Currently, the memory controller may check whether data stored in a storage cell of the memory is correct. When the data is incorrect, the memory controller may report memory fault information to an operating system via the processor, and the operating system may isolate a faulty storage cell.

As the electronic device runs for longer time, more storage cells are isolated. As a result, a quantity of available storage cells decreases.

### SUMMARY

Embodiments of this application provide a memory fault processing method and apparatus, an electronic device, and a readable storage medium, to release a storage cell at a low fault level and increase a quantity of available storage cells.

According to a first aspect, an embodiment of this application provides a memory fault processing method. The method may be performed by an electronic device or a chip in the electronic device. The following uses the electronic device as an example for description. The electronic device may detect a storage cell, and determine a faulty first storage cell. To avoid obtaining incorrect data from the faulty first storage cell, the electronic device may isolate the first storage cell. In embodiments of this application, after isolating the first storage cell, the electronic device may perform a pressure test on the first storage cell, to obtain a fault level of the first storage cell. Because a fault mode of some faulty storage cells is a reversible or recoverable fault, for example, a soft failure, if the electronic device keeps isolating the first storage cell, a quantity of available storage cells decreases.

In embodiments of this application, the electronic device may perform a corresponding operation on the first storage cell based on the fault level of the first storage cell. When the fault level of the first storage cell is a first risk level, the operation includes de-isolating the first storage cell. Because the electronic device may de-isolate the first storage cell, the first storage cell may continue to be used by the electronic device, and available storage cells in the electronic device may be increased.

In a possible implementation, the fault level of the first storage cell may further include a second risk level, and the first risk level is lower than the second risk level. When the fault level is the second risk level, performing the corresponding operation on the first storage cell may specifically include: de-isolating the first storage cell, and establishing a memory pool, where the memory pool is configured to manage the first storage cell, and the first storage cell is configured to store data backed up by an external storage.

In this implementation, for the second risk level higher than the first risk level, to prevent the first storage cell at the second risk level from continuing to evolve into a storage cell at a higher risk, the electronic device may de-isolate the first storage cell, and establish the memory pool, where the memory pool is configured to manage the first storage cell, and the first storage cell is configured to store the data backed up by the external storage.

In this implementation, the electronic device de-isolates the first storage cell, so that available storage cells in the electronic device can be increased. In addition, the first storage cell may store the data backed up by the external storage. In this way, even if the first storage cell is faulty or evolves to a storage cell at a higher risk, the electronic device may obtain the data backed up by the external storage, and normal data reading of the electronic device is not affected.

In some embodiments, the first risk level and the second risk level may indicate that the fault mode of the first storage cell is the soft failure.

In a possible implementation, when the fault level is a third risk level, the operation is continuing to isolate the first storage cell, and the second risk level is lower than the third risk level.

In this implementation, the third risk level indicates that the fault level of the first storage cell is high. Therefore, the electronic device may continue to isolate the first storage cell, to avoid reading incorrect data from the first storage cell.

In some embodiments, the third risk level may indicate that the fault mode of the first storage cell is a hard failure.

The following describes a process in which the electronic device performs a pressure test on the faulty first storage cell.

In some embodiments, the pressure test includes at least one of the following: a read/write test in at least one mode and a write interference test in at least one mode. For example, the pressure test may include the read/write test in the at least one mode. Alternatively, the pressure test may include the write interference test in the at least one mode. Alternatively, the pressure test includes the read/write test in the at least one mode and the write interference test in the at least one mode.

In a possible implementation, there is at least one first storage cell, and the pressure test may include the read/write test in the at least one mode. The electronic device may perform the following steps:
step A: write preset data into the at least one first storage cell;
step B: sequentially read the data from the at least one first storage cell in a sequence from a low address to a high address based on an address of the at least one first storage cell, and check the data in the first storage cell;
step C: when the check succeeds, write a complementary set of the preset data into the at least one first storage cell;
step D: sequentially read the data from the at least one first storage cell in a sequence from a low address to a high address based on the address of the at least one first storage cell, and check the data in the first storage cell;
step E: when the check succeeds, return to perform step A to step D, and perform step F after step A to step D are repeatedly performed for n times and all the checks succeed; and when any check fails, determine that the read/write test fails; or when the check fails, determine that the read/write test fails, where n is an integer greater than or equal to 1;
step F: write preset data into the at least one first storage cell;
step G: sequentially read the data from the at least one first storage cell in a sequence from a high address to a low address based on the address of the at least one first storage cell, and check the data in the first storage cell;
step H: when the check succeeds, write a complementary set of the preset data into the at least one first storage cell;
step I: sequentially read the data from the at least one first storage cell in a sequence from a high address to a low address based on the address of the at least one first storage cell, and check the data in the first storage cell; and
step J: when the check succeeds, return to perform step F to step I, and determine that the read/write test succeeds after step F to step I are repeatedly performed for m times and all the checks succeed; and when any check fails, determine that the read/write test fails; or when the check fails, determine that the read/write test fails, where m is an integer greater than or equal to 1.

In a possible implementation, there is at least one first storage cell, and the pressure test may include the write interference test in the at least one mode. The electronic device may write preset data into a storage cell near the at least one first storage cell, and record data in the first storage cell and in an adjacent row and an adjacent column of the first storage cell. The storage cell near the first storage cell may be understood as a storage cell that is X rows and Y columns away from the first storage cell, where both X and Y are integers greater than or equal to 1.

The electronic device may read the data from the first storage cell and from the adjacent row and the adjacent column of the first storage cell, and check the data in the first storage cell and the adjacent row and the adjacent column of the first storage cell. When the check succeeds, the electronic device may determine that the write test succeeds; or when the check fails, the electronic device may determine that the write test fails.

In some embodiments, when the pressure test includes the read/write test and the write interference test, the electronic device may obtain the fault level of the first storage cell according to the following method: for example, when the first storage cell passes the read/write test and the write interference test, determining that the fault level is the first risk level; when the first storage cell passes the read/write test but fails to pass the write interference test, determining that the fault level is the second risk level; or when the first storage cell fails to pass the read/write test and the write interference test, determining that the fault level is the third risk level, where the first risk level is lower than the second risk level, and the second risk level is lower than the third risk level.

In some embodiments, when the first storage cell passes the read/write test and the write interference test, or when the first storage cell passes the read/write test but fails to pass the write interference test, it is determined that the fault level is the second risk level, when the first storage cell fails to pass the read/write test and the write interference test, it is determined that the fault level is the third risk level.

In a possible implementation, the electronic device may further predict a faulty second storage cell based on the faulty first storage cell according to a preset processing algorithm, and isolate the second storage cell. In this way, the electronic device may perform a pressure test on the second storage cell to obtain a fault level of the second storage cell, and the electronic device may perform a corresponding operation on the second storage cell based on the fault level of the second storage cell. For a case in which the electronic device performs the pressure test on the second storage cell, and performs the corresponding operation on the second storage cell based on the fault level of the second storage cell, refer to related descriptions of the first storage cell.

In this embodiment of this application, the electronic device may predict the faulty second storage cell based on the faulty first storage cell, and the electronic device may perform pressure tests on the faulty first storage cell and the faulty second storage cell, so that the fault level of the faulty storage cell can be detected more completely, to accurately process the faulty storage cell.

In a possible implementation, a manner in which the electronic device isolates the storage cell is described herein. The first storage cell is used as an example. The electronic device may isolate the first storage cell according to the preset processing algorithm.

In a possible implementation, after obtaining the fault level of the first storage cell and the fault level of the second storage cell, the electronic device may optimize the preset processing algorithm based on the fault level of the first storage cell and the fault level of the second storage cell.

For example, the preset processing algorithm is that a storage cell whose quantity of error reporting times in a preset time period is greater than or equal to a quantity threshold is determined as the faulty storage cell. If the quantity threshold is set to an excessively small value, many non-faulty storage cells are isolated, and the quantity threshold in the preset processing algorithm is inaccurate. For example, the electronic device may increase the quantity threshold, to optimize the preset processing algorithm.

For example, when the preset processing algorithm is a machine learning algorithm, the electronic device may optimize a parameter in the machine learning algorithm based on a storage cell at a medium risk level and a storage cell at a low risk level, so that a faulty storage cell can be more accurately determined based on an optimized preset processing algorithm.

In this implementation, the electronic device may further optimize the preset processing algorithm based on the fault level of the first storage cell and the fault level of the second storage cell, to improve accuracy of the preset processing algorithm and reduce isolated storage cells.

According to a second aspect, an embodiment of this application provides a memory fault processing apparatus, including modules configured to perform the method according to the first aspect.

In a possible implementation, the memory fault processing apparatus may be an operating system in an electronic device.

In a possible implementation, the memory fault processing apparatus may include a fault determining module, an isolation module, a memory fault processing module, and a fault level management module. In some embodiments, the fault determining module may be a central processing unit or a memory controller in the electronic device.

The fault determining module is configured to determine a faulty first storage cell.

The isolation module is configured to isolate the first storage cell.

The fault level management module is configured to: perform a pressure test on the first storage cell to obtain a fault level of the first storage cell, and perform a corresponding operation on the first storage cell based on the fault level of the first storage cell, where when the fault level of the first storage cell is a first risk level, the operation includes de-isolating the first storage cell.

In a possible implementation, the fault level of the first storage cell further includes a second risk level, and the first risk level is lower than the second risk level.

When the fault level is the second risk level, the fault level management module is specifically configured to de-isolate the first storage cell, and establish a memory pool, where the memory pool is configured to manage the first storage cell, and the first storage cell is configured to store backup data.

In a possible implementation, when the fault level is a third risk level, the operation is continuing to isolate the first storage cell, and the second risk level is lower than the third risk level.

In a possible implementation, the pressure test includes at least one of the following: a read/write test in at least one mode and a write interference test in at least one mode.

In a possible implementation, there is at least one first storage cell, and the pressure test includes the read/write test in the at least one mode. The fault level management module is specifically configured to perform the following steps:
step A: write preset data into the at least one first storage cell;
step B: sequentially read the data from the at least one first storage cell in a sequence from a low address to a high address based on an address of the at least one first storage cell, and check the data in the first storage cell;
step C: when the check succeeds, write a complementary set of the preset data into the at least one first storage cell;
step D: sequentially read the data from the at least one first storage cell in a sequence from a low address to a high address based on the address of the at least one first storage cell, and check the data in the first storage cell;
step E: when the check succeeds, return to perform step A to step D, and perform step F after step A to step D are repeatedly performed for n times and all the checks succeed; and when any check fails, determine that the read/write test fails; or when the check fails, determine that the read/write test fails, where n is an integer greater than or equal to 1;
step F: write preset data into the at least one first storage cell;
step G: sequentially read the data from the at least one first storage cell in a sequence from a high address to a low address based on the address of the at least one first storage cell, and check the data in the first storage cell;
step H: when the check succeeds, write a complementary set of the preset data into the at least one first storage cell;
step I: sequentially read the data from the at least one first storage cell in a sequence from a high address to a low address based on the address of the at least one first storage cell, and check the data in the first storage cell; and
step J: when the check succeeds, return to perform step F to step I, and determine that the read/write test succeeds after step F to step I are repeatedly performed for m times and all the checks succeed; and when any check fails, determine that the read/write test fails; or when the check fails, determine that the read/write test fails, where m is an integer greater than or equal to 1.

**In** a possible implementation, there is at least one storage cell, and the pressure test includes the write interference test. The fault level management module is specifically configured to: write preset data into the at least one storage cell, and record data in an adjacent row and an adjacent column of the storage cell; and read the data from the adjacent row and the adjacent column of the storage cell, and check the data in the adjacent row and the adjacent column of the storage cell; and when the check succeeds, determine that the write test succeeds; or when the check fails, determine that the write test fails.

**In** a possible implementation, when the pressure test includes the read/write test and the write interference test, the fault level management module is specifically configured to: when the storage cell passes the read/write test and the write interference test, determine the fault level as the first risk level; when the storage cell passes the read/write test but fails to pass the write interference test, determine that the fault level is the second risk level; or when the storage cell fails to pass the read/write test and the write interference test, determine that the fault level is the third risk level, where the first risk level is lower than the second risk level, and the second risk level is lower than the third risk level.

In a possible implementation, the memory fault processing module is configured to predict a faulty second storage cell based on the first storage cell according to a preset processing algorithm.

The fault level management module is further configured to: perform a pressure test on the second storage cell to obtain a fault level of the second storage cell, and perform a corresponding operation on the second storage cell based on the fault level of the second storage cell.

In a possible implementation, the isolation module is specifically configured to isolate the first storage cell according to the preset processing algorithm.

In a possible implementation, the fault level management module is further configured to optimize the preset processing algorithm based on the fault level of the first storage cell and the fault level of the second storage cell.

According to a third aspect, an embodiment of this application provides an electronic device. The electronic device may include a processor and a memory. The memory is configured to store computer-executable program code, where the program code includes instructions. When the processor executes the instructions, the instructions cause the electronic device to perform the method according to the first aspect.

According to a fourth aspect, an embodiment of this application provides an electronic device. The electronic device may be the memory fault processing apparatus in the second aspect or the electronic device in the first aspect. The electronic device may include a cell, a module, or a circuit configured to perform the method provided in the first aspect.

According to a fifth aspect, an embodiment of this application provides a computer program product including instructions. When the computer program product is run on a computer, the computer is enabled to perform the method according to the first aspect.

According to a sixth aspect, an embodiment of this application provides a computer-readable storage medium. The computer-readable storage medium stores instructions, and when the instructions are run on a computer, the computer is enabled to perform the method according to the first aspect.

For beneficial effect of the possible implementations of the second aspect to the sixth aspect, refer to the beneficial effect brought by the first aspect. Details are not described herein again.

### BRIEF DESCRIPTION OF DRAWINGS

FIG. 1 is a diagram of a structure of an electronic device according to an embodiment of this application;
FIG. 2 is a schematic flowchart of an embodiment of a memory fault processing method according to an embodiment of this application;
FIG. 3A to FIG. 3C are a schematic flowchart of a pressure test according to an embodiment of this application;
FIG. 4 is a schematic flowchart of another embodiment of a memory fault processing method according to an embodiment of this application;
FIG. 5 is a schematic flowchart of another embodiment of a memory fault processing method according to an embodiment of this application;
FIG. 6 is a schematic flowchart of another embodiment of a memory fault processing method according to an embodiment of this application;
FIG. 7 is a schematic flowchart of another embodiment of a memory fault processing method according to an embodiment of this application;
FIG. 8 is a schematic flowchart of another embodiment of a memory fault processing method according to an embodiment of this application; and
FIG. 9 is a diagram of another structure of an electronic device according to an embodiment of this application.

### DESCRIPTION OF EMBODIMENTS

Definitions of terms in embodiments of this application are as follows:
Memory: The memory is storage space that is in an electronic device and that is configured to temporarily store data. The memory may be configured to temporarily store operation data of a processor in the electronic device, data exchanged with the external such as a hard disk, and the like.

Storage cell (cell): The storage cell is a minimum cell for data storage. The memory may include a plurality of storage cells. Each storage cell may include one transistor and one capacitor. The capacitor may store an electric charge, and the electric charge stored in the capacitor may represent a binary digit 0 or 1. One digit may be referred to as one bit (1 bit), and 8 bits are one byte. Each storage cell has a unique address, and data in the corresponding storage cell may be accessed through the address.

In some embodiments, the storage cell may also be referred to as a memory cell, a memory cell, or the like. This is not limited in embodiments of this application.

Memory bank (bank): In some embodiments, the memory bank may be understood as a logical storage bank in a memory. The memory may include a plurality of memory banks, and each memory bank may include a two-dimensional matrix arranged by storage cells.

Rows and columns in the memory: One memory module usually has a plurality of memory banks (banks), and storage cells in one memory bank are arranged in a form of a two-dimensional matrix. Rows (rows) and columns (columns) in the two-dimensional matrix are rows and columns in the memory. In some embodiments, one storage cell may be uniquely determined by specifying a row and a column in the memory bank.

A memory row may be understood as a row to which the storage cell belongs, and a memory column may be understood as a column to which the storage cell belongs.

Physical address: The physical address is an address of a location actually occupied by a storage cell in the memory. For example, if a size of the memory is 2 GB, a range of the physical address may be 0 GB to 2 GB.

Logical address: The logical address is a representation form of an address that is of a storage cell and that corresponds to an operating system. Currently, in a segment storage management manner, a memory may be divided into a plurality of logical segments, to isolate different data storage. In this case, the address of the storage cell is described in a form of "segment start address + in-segment offset address", and the logical address of the storage cell may include the segment start address and the in-segment offset address.

In some embodiments, the logical address of the storage cell may be considered as a specific description of a virtual address of the storage cell.

Virtual address: The virtual address is an address used by a central processing unit (central processing unit, CPU) to search for a storage cell. Because the processor can use only the physical address, the virtual address needs to be translated into the physical address before being used by the processor. This translation process may be completed by a memory management unit (memory management unit, MMU) in an operating system (operating system, OS). For example, in a 32-bit operating system, a size of virtual memory space may be 0 GB to 4 GB.

A page table is used to store a mapping relationship between a virtual address and a physical address. The MMU may find, from the page table, a physical address to which the virtual address is mapped, and then submit the physical address to the processor. The processor may write data into or read data from a corresponding storage cell based on the physical address. The memory mapping is in a unit of a memory page. Generally, a size of one memory page is 4 KB. For example, a size of data that can be accessed by the processor at a time is 4 KB.

It may be understood that each storage cell has a corresponding physical address, virtual address, and logical address, and the physical address, the virtual address, and the logical address of each storage cell are in a one-to-one correspondence.

Correctable error (correctable error, CE): The correctable error usually refers to an error of a single bit in data. A memory controller can detect, through check, a bit in which an error occurs in the data, and error correction effect can be achieved by flipping the bit in which the error occurs.

Uncorrectable error (uncorrectable error, UCE): The uncorrectable error usually refers to the presence of a plurality of bit errors in data. For uncorrectable errors, the memory controller cannot correct such errors.

Soft failure: The physical structure of the memory is not damaged, but the data in the storage cell is incorrect due to electromagnetic radiation and electric charge loss. The data can be restored after the memory is charged and discharged again. For example, when high-energy subatomic particles pass through the storage cell in the memory, free electric charges are generated. These free electric charges gather on the storage cell in an extremely short time interval. When the accumulated free electric charges exceed a specific degree, the data stored in the storage cell changes, and a data error occurs. A soft failure does not permanently damage the storage cell. When data is corrected and written back to the memory, the data error can be rectified.

Bit reversal: The electric charge stored in the storage cell changes, resulting in that read the data is opposite to the expected data. For example, 1 is read from a storage cell that should store 0, or 0 is read from a storage cell that should store 1. In some embodiments, bit reversal of the storage cell may be caused due to electromagnetic rays, electric charge loss, or the like.

Hard failure: The physical structure of the memory is damaged, and cannot be rectified even if the system is restarted or the storage cell is charged or discharged again.

Risky memory: The risky memory refers to a faulty storage cell. In some embodiments, the risky memory may also be referred to as a faulty memory.

The electronic device in embodiments of this application is a device including a memory, for example, may be a server, a storage controller, a switch, a router, a base station controller, a computation offloading card, a computation acceleration card, or a terminal device. In some embodiments, the terminal device may be referred to as user equipment (user equipment, UE), a terminal (terminal), or the like. For example, the terminal device may be a mobile phone, a tablet computer (portable Android device, PAD), a personal digital processing (personal digital assistant, PDA), a handheld device with a wireless communication function, a computing device, a vehicle-mounted device or a wearable device, a virtual reality (virtual reality, VR) terminal device, an augmented reality (augmented reality, AR) terminal device, a terminal in industrial control (industrial control), a terminal in smart home (smart home), or the like. A form of the electronic device is not specifically limited in embodiments of this application.

The electronic device may include a memory controller, a processor, and an operating system. Currently, an error checking and correction (error checking and correction, ECC) algorithm, an on-die ECC algorithm, and the like are error checking and correction algorithms applicable to a memory, a cache (cache), or another storage medium.

For example, the memory controller runs ECC. When the memory controller needs to write data into the memory, the memory controller calculates a verification code based on the to-be-written data, and writes both the data and the verification code of the data into the storage cell. When the memory controller needs to read data from the storage cell, the memory controller also reads the verification code in the storage cell when reading the data from the storage cell. The memory controller may obtain a verification code through recalculation by using the obtained data, and compare the verification code read from the storage cell with the recalculated verification code. If the verification code read from the storage cell is consistent with the recalculated verification code, it indicates that the data is correct, and the check succeeds. If the verification code read from the storage cell is inconsistent with the recalculated verification code, it indicates that the data is incorrect, and the check fails.

When the check fails, the memory controller attempts to perform error correction through the verification code, and reports memory fault information to the processor. The processor may report the memory fault information to the operating system. Based on whether the memory controller can correct errors, fault information is classified into a correctable error and an uncorrectable error. Generally, single-bit reversal can be corrected, and multi-bit reversal cannot be corrected. Currently, a faulty storage cell may be processed in a hardware isolation manner or a software isolation manner.

Hardware isolation is used as an example. A basic input/output system (basic input/output system, BIOS) may process the faulty storage cell. For example, the BIOS may count a quantity of reporting times of the memory fault information. When a quantity of reporting times of memory fault information of a same storage cell is greater than a quantity threshold, the BIOS may deliver a command to isolate the storage cell. For example, the BIOS may deliver a command to isolate a memory row or a memory bank to which the faulty storage cell belongs. An operation of isolating the memory bank is irreversible.

Software isolation is used as an example. The OS may count a quantity of times of reporting memory fault information. When a quantity of times of reporting memory fault information of a same storage cell is greater than a quantity threshold, the OS may deliver a command to trigger memory page isolation, isolating virtual space that is of a faulty area and that is in the OS and that corresponds to the faulty memory cell. In this method, the OS can only isolate the virtual space of the faulty area in the OS, and cannot invoke a storage cell resource in the memory, and after isolation is performed by the OS layer, memory space is reduced. Especially for huge page isolation, an isolation risk is high, and a system breakdown is easily caused.

In conclusion, in a current memory fault processing method, regardless of hardware isolation or software isolation, a faulty storage cell is permanently isolated. Even if the isolation operation is reversible, as the electronic device runs for longer time, more storage cells are isolated. As a result, a quantity of available storage cells decreases, and a memory may be reduced.

With development of the current memory technology, a diameter of the storage cell becomes smaller and smaller, the bit reversal is more likely to occur in the storage cell due to charging and discharging operations of a surrounding storage cell, and the row hammer occurs. As a result, a proportion of soft failures of the storage cell increases. However, the soft failure does not mean that a physical structure of the memory is damaged. Actually, the storage cell is still available. Currently, hardware isolation and software isolation permanently isolate the storage cell in which the soft failure occurs. As a result, the originally available storage cell cannot be used by the electronic device, and a quantity of available storage cells gradually decreases.

Therefore, an embodiment of this application provides a memory fault processing method, to perform a pressure test on a faulty storage cell, and determine a fault level of the faulty storage cell. When the fault level of the storage cell is a low level, for example, when the storage cell has a soft failure, the electronic device may de-isolate the storage cell, so that the storage cell can continue to store data, to increase available storage cells. In addition, in this embodiment of this application, for storage cells at different fault levels, the electronic device may perform different operations on the storage cells. This not only increases available storage cells, but also improves memory management flexibility.

Before the memory fault processing method provided in embodiments of this application is described, a structure of an electronic device provided in embodiments of this application is first described.

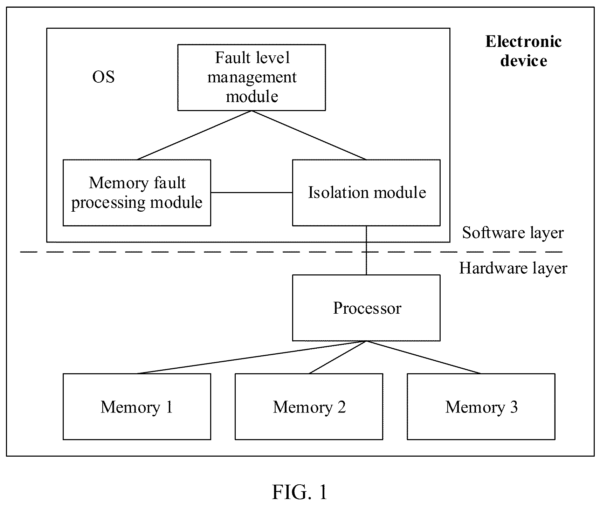

FIG. 1 is a diagram of a structure of an electronic device according to an embodiment of this application. Refer to FIG. 1. The electronic device may include a hardware layer and a software layer, and the software layer may include program code running on the hardware layer.

In some embodiments, the software layer may be further divided into several layers, and the layers communicate with each other through a software interface. For example, the software layer may include an application layer, an OS, a BIOS, and the like. It should be understood that FIG. 1 shows only the OS in this embodiment of this application.

The OS is a system running in a CPU. In some embodiments, the OS may include but is not limited to Linux, Windows, Android, VxWorks, or the like. This is not limited in embodiments of this application.

Refer to FIG. 1. In some embodiments, the OS may include an isolation module, a memory fault processing module, and a fault level management module. In some embodiments, the OS may further include an MMU. The MMU may store a page table, to implement translation between a physical address and a virtual address of the storage cell. For a function of the MMU, refer to related descriptions in the conventional technology. It should be understood that FIG. 1 shows only the isolation module, the memory fault processing module, and the fault level management module in this embodiment of this application.

The isolation module is configured to: receive memory fault information from a processor, and report the memory fault information to the memory fault processing module and the fault level management module.

The memory fault management module may obtain a processing decision of a faulty storage cell according to a preset processing algorithm, and send the processing decision to the isolation module.

The isolation module is configured to isolate the faulty storage cell based on the processing decision.

The fault level management module is configured to perform a pressure test on the faulty storage cell based on the memory fault information, to obtain a fault level of the storage cell.

In some embodiments, after obtaining the processing decision, the memory fault management module may further send the processing decision to the fault level management module. Correspondingly, the fault level management module may be further configured to perform a pressure test on the faulty storage cell based on the memory fault information and the processing decision, to obtain the fault level of the storage cell.

The fault level management module may be further configured to perform different operations on the storage cell based on the fault level of the storage cell. For details, refer to related descriptions in the following embodiments.

It may be understood that steps performed by the isolation module, the memory fault processing module, and the fault level management module in the following embodiments may be considered as steps performed by the OS.

In some embodiments, the hardware layer may include a processor CPU, a memory, a BIOS chip, a baseboard management controller (baseboard management controller, BMC), and the like.

In some embodiments, the memory may include a main memory and an external storage. It should be understood that FIG. 1 shows only the processor and the memory in this embodiment of this application, and FIG. 1 shows that the electronic device may include at least one memory. In FIG. 1, an example in which the electronic device includes three memories is used for description. In some embodiments, the memory may be a memory module.

In some embodiments, the hardware layer may further include a memory controller. In some embodiments, the memory controller may be disposed in the processor, or may be disposed separately from the processor. This is not limited in embodiments of this application. In FIG. 1, an example in which the memory controller is disposed in the processor is used.

The memory controller is configured to check data in the storage cell, and report the memory fault information to the processor when the data is incorrect. It should be understood that, when the memory controller is disposed in the processor, steps performed by the memory controller may be considered as steps performed by the processor. In some embodiments, the processor may check data in a storage cell, and when the data is incorrect, report memory fault information to an operating system (for example, an isolation module in the operating system).

It may be understood that steps performed by the isolation module, the memory fault processing module, the fault level management module, the processor, and the like in the following embodiments may be considered as steps performed by the electronic device.

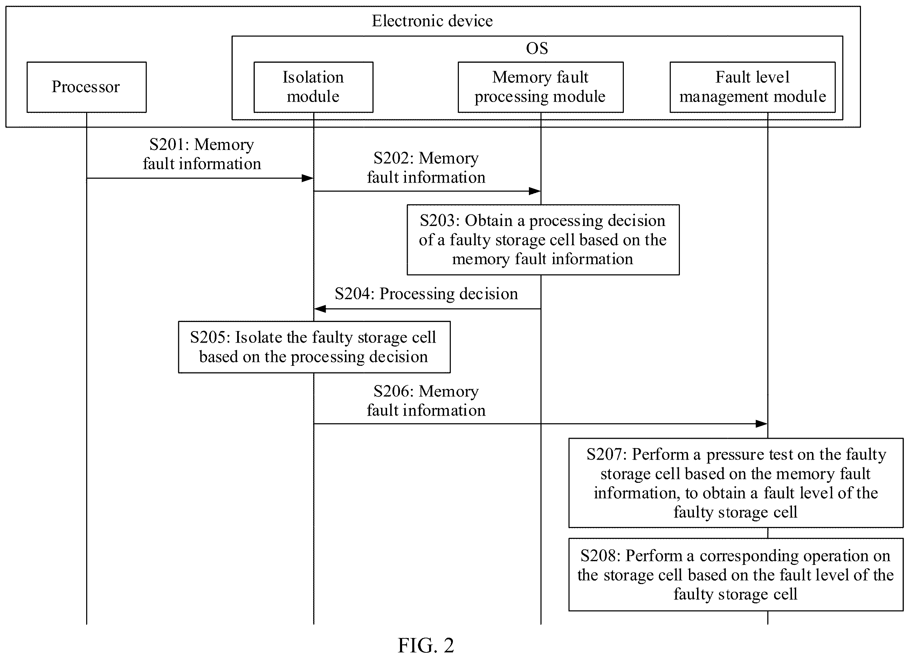

The following describes the memory fault processing method provided in embodiments of this application with reference to specific embodiments. The following several embodiments may be combined with each other, and a same or similar concept or process may not be described repeatedly in some embodiments. In FIG. 2, a memory fault processing method provided in this embodiment of this application is described from a perspective of interaction between internal modules in an electronic device.

FIG. 2 is a schematic flowchart of an embodiment of a memory fault processing method according to an embodiment of this application. Refer to FIG. 2. The memory fault processing method provided in this embodiment of this application may include the following steps.

S201: A processor reports memory fault information to an isolation module.

In this embodiment of this application, the processor may check data in a storage cell according to an ECC algorithm, an on-die ECC algorithm, or the like. When the check fails, the processor may determine that the storage cell is faulty, and the processor may report the memory fault information to the isolation module. Alternatively, a memory controller may check data in a storage cell according to an ECC algorithm, an on-die ECC algorithm, or the like. When the check fails, the memory controller may determine that the storage cell is faulty, the memory controller may report the memory fault information to the processor, and the processor may report the memory fault information to the isolation module.

In some embodiments, the memory fault information may include a physical address and a logical address of the faulty storage cell. In some embodiments, the logical address of the storage cell may be a logical address of a cache line to which the storage cell belongs, or a logical address of a memory page to which the storage cell belongs. This is not limited in embodiments of this application.

S202: The isolation module sends the memory fault information to a memory fault processing module.

S203: The memory fault processing module obtains a processing decision of the faulty storage cell based on the memory fault information.

A preset processing algorithm may be preset in the memory fault processing module, and the memory fault processing module may process the memory fault information according to the preset processing algorithm, to obtain the processing decision of the faulty storage cell.

In some embodiments, the preset processing algorithm may be that, for example, a storage cell whose quantity of error reporting times in a preset time period is greater than or equal to a quantity threshold is determined as the faulty storage cell. In this embodiment, each time the memory fault processing module receives the memory fault information, the memory fault processing module may add 1 to a quantity of error reporting times of a faulty cell in the memory fault information. When the quantity of error reporting times of the storage cell reaches the quantity threshold, the memory fault processing module may determine that the storage cell is the faulty storage cell.

In some embodiments, the processing decision of the faulty storage cell may be "isolating the faulty storage cell".

In some embodiments, for a storage cell in use, a processing decision of the faulty storage cell may be "performing remapping, that is, migrating data in the faulty storage cell to a secure storage cell, and isolating the faulty storage cell." The secure storage cell may be a non-faulty storage cell. A physical address of the secure storage cell may be referred to as a secure physical address, and a logical address of the secure storage cell may be referred to as a secure logical address. In some embodiments, the secure physical address and the secure logical address may be referred to as secure addresses.

In some embodiments, the processing decision may further include an isolation manner of the storage cell, and the isolation manner may include but is not limited to hardware isolation and software isolation. For example, the hardware isolation may include but is not limited to isolating the faulty storage cell, isolating the cache line to which the faulty storage cell belongs, isolating the memory page to which the faulty storage cell belongs, and the like. The software isolation may include but is not limited to page isolation, address isolation, process isolation, and the like.

In some embodiments, the memory fault information may further include a fault type. For example, the fault type may include but is not limited to a page fault, a single-bit fault, a cell fault, a row fault, a column fault, a bank fault, and the like.

The preset processing algorithm may be that, for example, the isolation manner of processing the storage cell based on the fault type is determined. Correspondingly, the processing decision may include the isolation manner of the faulty storage cell.

In some embodiments, the preset processing algorithm may be a preset machine learning algorithm. The memory fault processing module may input the memory fault information into the machine learning algorithm, and the machine learning algorithm may output the processing decision of the faulty storage cell. For example, the machine learning algorithm may include but is not limited to a decision tree algorithm, a supervised machine learning algorithm, an unsupervised machine learning algorithm, and the like. For example, the memory fault processing module may determine the fault type of the storage cell based on the decision tree algorithm, a random forest algorithm, a neural network algorithm, or the like, and determine, based on the fault type, whether the isolation manner of the storage cell is the hardware isolation or the software isolation.

The preset processing algorithm preset in the memory fault processing module is not limited in embodiments of this application.

S204: The memory fault processing module sends the processing decision to the isolation module.

In some embodiments, the processing decision may include a to-be-isolated address and an isolation manner. The to-be-isolated address may include but is not limited to the address of the faulty storage cell, an address of the cache line to which the faulty storage cell belongs, an address of the memory page to which the faulty storage cell belongs, or the like.

In some embodiments, the to-be-isolated address may be a physical address, a logical address, or a virtual address.

In some embodiments, the processing decision may include a to-be-isolated address, an isolation manner, and a secure address. The secure address indicates to migrate data at the to-be-isolated address to the secure address.

S205: The isolation module isolates the faulty storage cell based on the processing decision.

In some embodiments, the isolation module may isolate the faulty storage cell based on the to-be-isolated address and the isolation manner. Specifically, for example, the isolation module may isolate the faulty storage cell, the cache line to which the faulty storage cell belongs, or the memory page to which the faulty storage cell belongs.

In some embodiments, the isolation module may further first migrate, based on the to-be-isolated address and the secure address, data corresponding to the to-be-isolated address to the secure address, and then isolate the faulty storage cell.

In this embodiment of this application, a reason why the isolation module first isolates the faulty storage cell based on the processing decision is that an error occurs in data in the storage cell because the faulty storage cell is a storage cell in which an error occurs, and the isolation module first isolates the faulty storage cell, to prevent the electronic device from accessing a risky memory and reading incorrect data, and prevent the electronic device from being faulty.

S206: The isolation module sends the memory fault information to a fault level management module.

There is no sequence difference between S206 and S202, and S206 and S202 may be performed simultaneously.

S207: The fault level management module performs a pressure test on the faulty storage cell based on the memory fault information, to obtain a fault level of the faulty storage cell.

The fault level management module may determine the faulty storage cell based on the memory fault information. In this embodiment of this application, the fault level management module may perform the pressure test on the faulty storage cell, to obtain a fault mode and the fault level of the faulty storage cell. The pressure test can be regarded as a pressure test.

In some embodiments, to avoid affecting normal execution of a service in the electronic device, the fault level management module may perform the pressure test on the faulty storage cell when the electronic device is idle. That the electronic device is idle may be understood as that CPU usage is lower than preset usage, or a user does not use the electronic device in the early morning every day, or the like.

In some embodiments, the pressure test on the faulty storage cell may include a read/write test or a write interference test.

For example, when the pressure test includes the read/write test, the fault level management module may deliver a write instruction to the processor, where the write instruction instructs the processor to write preset data into the faulty storage cell. After the processor writes the preset data into the faulty storage cell, the fault level management module may deliver a read instruction to the processor. The read instruction instructs the processor to read the preset data from the faulty storage cell, and check whether the data in the faulty storage cell is correct. When the data in the faulty storage cell is correct, for example, the data is the preset data, it may be determined that the check on the faulty storage cell succeeds, and the faulty storage cell may be a fault at a low risk level. When the data in the faulty storage cell is incorrect, for example, the data is not the preset data, it may be determined that the check on the faulty storage cell fails, and the faulty storage cell may be a fault at a high risk level.

In some embodiments, for example, the fault at the high risk level may include a hard failure, and the fault at the low risk level may include a soft failure. In this embodiment of this application, specific fault modes included in the fault at a high risk level and the fault at a low risk level are not limited.

In some embodiments, the read/write test may include a read/write test in at least one mode. For example, the read/write test in the at least one mode includes a first read/write test and a second read/write test. In this embodiment of this application, a process in which the fault level management module interacts with the processor to complete the first read/write test and the second read/write test is not described in detail. For details, refer to related descriptions of the foregoing read/write test.

When the faulty storage cell passes the first read/write test and the second read/write test, it may be determined that the faulty storage cell may be a fault at a low risk level; when the faulty storage cell passes the first read/write test but fails to pass the second read/write test, it may be determined that the faulty storage cell may be a fault of a medium risk level; or when the faulty storage cell fails to pass the first read/write test and the second read/write test, it may be determined that the faulty storage cell may be a fault at a high risk level.

For example, when the pressure test includes the write interference test, the fault level management module may deliver a write instruction to the processor, where the write instruction instructs the processor to write preset data near the faulty storage cell. In some embodiments, storage cells near the faulty storage cell may be, for example, storage cells that are X rows and Y columns away from the faulty storage cell, where both X and Y are integers greater than or equal to 1. Before the processor writes the preset data into the faulty storage cell, the processor may record data in the faulty storage cell and data in storage cells in an adjacent row and an adjacent column of the faulty storage cell. After the processor writes the preset data near the faulty storage cell for at least one time, the fault level management module may deliver a read instruction to the processor. The read instruction instructs the processor to read data from the faulty storage cell and data in storage cells in an adjacent row and an adjacent column of the faulty storage cell. When data read from the faulty storage cell and data in storage cells in an adjacent row and an adjacent column of the faulty storage cell is correct, it may be determined that the faulty storage cell may be a fault at a low risk level. When data read from the faulty storage cell and data in storage cells in an adjacent row and an adjacent column of the faulty storage cell is incorrect, it may be determined that the faulty storage cell may be a fault at a high risk level.

In some embodiments, the write interference test may include a write interference test in at least one mode. For example, the write interference test in the at least one mode includes a first write interference test and a second write interference test. In this embodiment of this application, a process in which the fault level management module interacts with the processor to complete the first write interference test and the second write interference test is not described in detail. For details, refer to the foregoing related descriptions of the write interference test.

When the faulty storage cell passes the first write interference test and the second write interference test, it may be determined that the faulty storage cell may be a fault at a low risk level; when the faulty storage cell passes the first write interference test but fails to pass the second write interference test, it may be determined that the faulty storage cell may be a fault of a medium risk level; or when the faulty storage cell fails to pass the first write interference test and the second write interference test, it may be determined that the faulty storage cell may be a fault at a high risk level.

In some embodiments, the pressure test on the faulty storage cell may include a read/write test and a write interference test. In some embodiments, the pressure test may include the read/write test in the at least one mode and the write interference test in the at least one mode. In the following example, the pressure test includes a plurality of read/write tests and one write interference test. A pressure test manner of the faulty storage cell is not limited in embodiments of this application.

In some embodiments, there may be at least one faulty storage cell. The fault level management module may sequentially perform a pressure test on each faulty storage cell, or simultaneously perform a pressure test on at least one faulty storage cell. To improve pressure test efficiency, in this embodiment of this application, a pressure test may be simultaneously performed on at least one faulty storage cell.

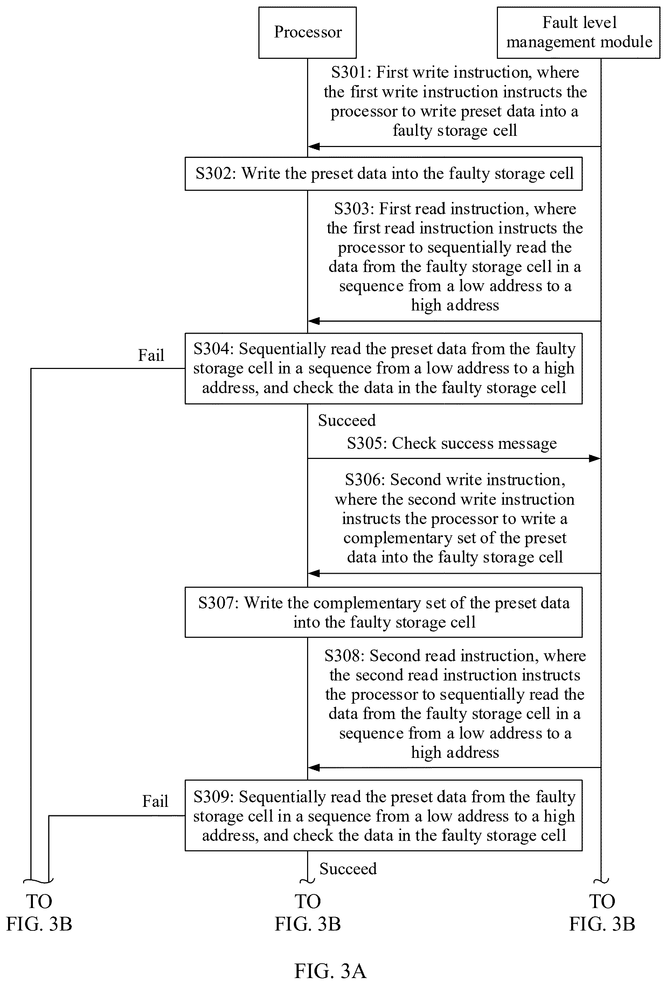

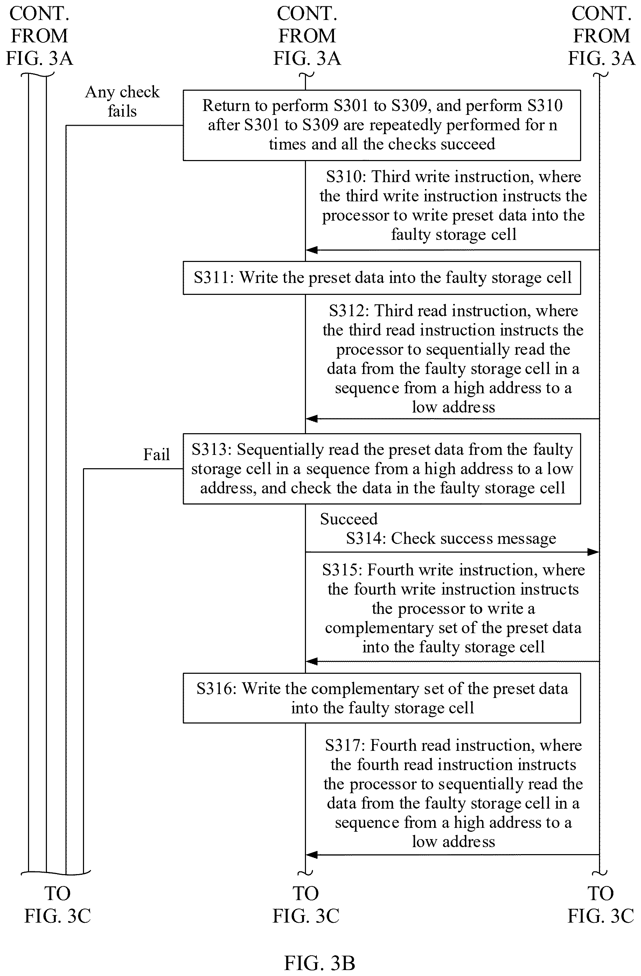

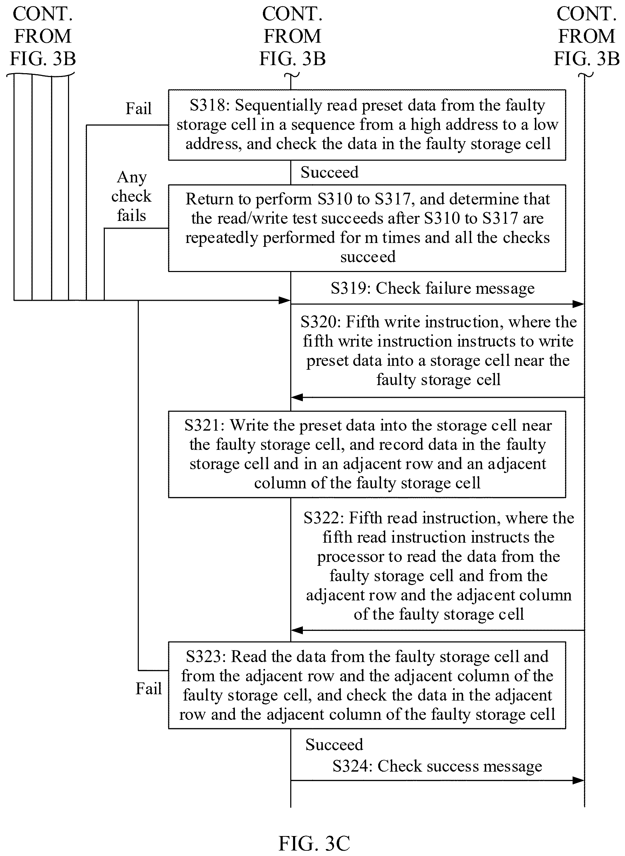

For example, refer to FIG. 3A to FIG. 3C. The pressure test process provided in this embodiment of this application may include the following steps.

S301: A fault level management module delivers a first write instruction to a processor, where the first write instruction instructs the processor to write preset data into a faulty storage cell.

The preset data may be, for example, data that is all 0s or all 1s, or data sorted in a preset mode. In the preset mode, for example, 0 and 1 are alternately written, or M 0s are written and N 1s are alternately written. This is not limited in embodiments of this application. It should be understood that both M and N are integers greater than or equal to 1.

S302: The processor writes the preset data into the faulty storage cell.

S303: The fault level management module delivers a first read instruction to the processor, where the first read instruction instructs the processor to sequentially read the data from the faulty storage cell in a sequence from a low address to a high address.

The address may be a physical address, a logical address, or a virtual address of the storage cell. The physical address is obtained by sorting based on actual locations of the storage cells in memory, and the logical address and the virtual address are obtained by mapping the physical address. Therefore, the addresses of the storage cells are sorted. For example, the physical address is used as an example. For example, if a physical address of the memory is 0 GB to 2 GB, the address sequentially increases from 0 GB to 2 GB. 0 GB is a lower address than 1 GB, and 1 GB is a lower address than 2 GB.

S304: The processor sequentially reads the preset data from the faulty storage cell in a sequence from a low address to a high address, and checks the data in the faulty storage cell. When the check succeeds, S305 is performed; or when the check fails, S319 is performed.

A process in which the processor checks the data in the faulty storage cell is not described in detail in this embodiment of this application. For details, refer to related descriptions in the foregoing embodiment.

S305: The processor feeds back a check success message to the fault level management module.

S306: The fault level management module delivers a second write instruction, where the second write instruction instructs the processor to write a complementary set of the preset data into the faulty storage cell.

The complementary set may be understood as data opposite to the preset data. For example, when the preset data is all 1s, the complementary set of the preset data is all 0s. For example, when the preset data alternates between 0 and 1, the complementary set of the preset data alternates between 1 and 0. For example, when M 0s are written, and N 1s are alternately written for the preset data, M 1s are written and N 0s are alternately written for the complementary set.

S307: The processor writes the complementary set of the preset data into the faulty storage cell.

S308: The fault level management module delivers a second read instruction to the processor, where the second read instruction instructs the processor to sequentially read the data from the faulty storage cell in a sequence from a low address to a high address.

S309: The processor sequentially reads the preset data from the faulty storage cell in a sequence from a low address to a high address, and checks the data in the faulty storage cell. When the check succeeds, S301 to S309 are performed again. After S301 to S309 are repeatedly performed for n times and all the checks succeed, S310 is performed; and when any check fails, S319 is performed; or when the check fails, S319 is performed.

n is an integer greater than or equal to 1.

S310: The fault level management module delivers a third write instruction to the processor, where the third write instruction instructs the processor to write preset data into the faulty storage cell.

S311: The processor writes the preset data into the faulty storage cell.

S312: The fault level management module delivers a third read instruction to the processor, where the third read instruction instructs the processor to sequentially read the data from the faulty storage cell in a sequence from a high address to a low address.

S313: The processor sequentially reads the preset data from the faulty storage cell in a sequence from a high address to a low address, and checks the data in the faulty storage cell. When the check succeeds, S314 is performed; or when the check fails, S319 is performed.

S314: The processor feeds back a check success message to the fault level management module.

S315: The fault level management module delivers a fourth write instruction, where the fourth write instruction instructs the processor to write a complementary set of the preset data into the faulty storage cell.

S316: The processor writes the complementary set of the preset data into the faulty storage cell.

S317: The fault level management module delivers a fourth read instruction to the processor, where the fourth read instruction instructs the processor to sequentially read the data from the faulty storage cell in a sequence from a high address to a low address.

S318: The processor sequentially reads preset data from the faulty storage cell in a sequence from a high address to a low address, and checks the data in the faulty storage cell. When the check succeeds, S310 to S317 are performed again. After S310 to S317 are repeatedly performed for m times and all the checks succeed, it is determined that a read/write test succeeds; and when any check fails, S319 is performed; or when the check fails, S319 is performed.

m is an integer greater than or equal to 1, and m and n may be the same or different.

S319: The processor feeds back a check failure message to the fault level management module.

S301 to S319 may be considered as a read/write test. S301 to S304 may be considered as a read/write test of a mode, S306 to S309 may be considered as a read/write test of a mode, S310 to S313 may be considered as a read/write test of a mode, and S315 to S318 may be considered as a read/write test of a mode.

In this embodiment of this application, when the storage cell passes the read/write tests in all modes, it may be determined that the storage cell passes the read/write tests. When the storage cell fails to pass the read/write test in any mode or fails to pass any check, it may be determined that the storage cell fails to pass the read/write test.

S320: The fault level management module delivers a fifth write instruction to the processor, where the fifth write instruction instructs the processor to write preset data into a storage cell near the faulty storage cell.

S321: The processor writes preset data into a storage cell near the faulty storage cell, and records data in the faulty storage cell and in an adjacent row and an adjacent column of the faulty storage cell.

In some embodiments, the processor may record data in x adjacent rows and y adjacent columns of the faulty storage cell. Both x and y are integers greater than or equal to 1, and x and y may be the same or different.

S322: The fault level management module delivers a fifth read instruction to the processor, where the fifth read instruction instructs the processor to read the data from the faulty storage cell and from the adjacent row and the adjacent column of the faulty storage cell.

S323: The processor reads the data from the faulty storage cell and from the adjacent row and the adjacent column of the faulty storage cell, and checks the data in the faulty storage cell and in the adjacent row and the adjacent column of the faulty storage cell. When the check succeeds, S324 is performed; or when the check fails, S319 is performed.

S324: The processor feeds back a check success message to the fault level management module.

S320 to S323 may be considered as a write interference test. In S323, when the check succeeds, it may be determined that the storage cell passes the write interference test; or when the check fails, it may be determined that the storage cell fails to pass the write interference test.

It should be understood that, in this embodiment of this application, a sequence of the read/write test and the write interference test is not limited, and a quantity of times of performing the read/write test and the write interference test is not limited. FIG. 3A to FIG. 3C are an example for description. In an embodiment, some steps shown in FIG. 3A to FIG. 3C are optional steps, and the steps may be combined with each other.

In some embodiments, when the faulty storage cell passes the read/write test and the write interference test, the fault level management module may determine that a fault level is a low risk level; when the faulty storage cell passes the read/write test but fails to pass the write interference test, the fault level management module may determine that a fault level is a medium risk level; or when the faulty storage cell fails to pass the read/write test and the write interference test, the fault level management module may determine that a fault level is a high risk level.

In some embodiments, in a scenario with a high reliability requirement, when the faulty storage cell passes the read/write test and the write interference test, and when the faulty storage cell passes the read/write test but fails to pass the write interference test, the fault level management module may determine that a fault level is the medium risk level. When the faulty storage cell fails to pass the read/write test and the write interference test, the fault level management module may determine that a fault level is the high risk level.

In this embodiment of this application, the fault level management module may adaptively adjust, based on a specific application scenario and a pressure test result, a method for determining a fault level of the faulty storage cell. In some embodiments, the fault level management module may store a mapping relationship between an application scenario and a method for determining a fault level of a faulty storage cell. When the fault level management module determines the fault level of the faulty storage cell based on the pressure test result, the fault level of the storage cell may be determined according to a method for determining a fault level of a faulty storage cell corresponding to an application scenario.

S208: The fault level management module performs a corresponding operation on the storage cell based on the fault level of the faulty storage cell.

In some embodiments, a fault of a storage cell at a high risk level may be considered as a hard failure, and a fault of a storage cell at a medium risk level or a storage cell at a low risk level may be considered as a soft failure. In this embodiment of this application, storage cells at different fault levels are processed in different manners.

In some embodiments, a storage cell at a high risk level may continue to be prohibited from being used, for example, the storage cell at the high risk level may continue to be isolated. In some embodiments, for a storage cell at a high risk level, the fault level management module may feed back the storage cell at the high risk level to the memory fault processing module, and the memory fault processing module may write the fault into a log, or feed back the fault to a background management page for an operation and maintenance alarm.

A storage cell at a medium risk level may be restricted for use to prevent the storage cell from evolving into a high-risk storage cell. For example, the fault level management module may establish an independent memory pool to manage the storage cell. The storage cell is configured to store data that is insensitive to a hardware fault. For example, the storage cell may store data that is backed up by an external storage, such as a file or a document. In this way, even if the storage cell is faulty, the electronic device can still obtain the corresponding data from the backup.

A storage cell at a low risk level may be restored to normal use. For example, the fault level management module may send a de-isolation request to the isolation module, to request the isolation module to de-isolate the storage cell. In this way, the storage cell can continue to store data.

In some embodiments, for a storage cell at a medium risk level and a storage cell at a low risk level, these storage cells are still available, and there is no problem of irreversibility in a physical structure. The preset processing algorithm in the memory fault processing module may be inaccurate. In this embodiment, the fault level management module may feed back the storage cell at the medium risk level and the storage cell at the low risk level to the memory fault processing module, so that the memory fault processing module can optimize the preset processing algorithm.

For example, the preset processing algorithm is that a storage cell whose quantity of error reporting times in a preset time period is greater than or equal to a quantity threshold is determined as the faulty storage cell. If the quantity threshold is set to an excessively small value, many non-faulty storage cells are isolated, and the quantity threshold in the preset processing algorithm is inaccurate. For example, the memory fault processing module may increase a quantity threshold, to optimize the preset processing algorithm.

For example, when the preset processing algorithm is a machine learning algorithm, the memory fault processing module may optimize a parameter in the machine learning algorithm based on a storage cell at a medium risk level and a storage cell at a low risk level, so that a faulty storage cell can be more accurately determined based on an optimized preset processing algorithm.

In some embodiments, the low risk level may be used as a first risk level, the medium risk may be used as a second risk level, and the high risk level may be used as a third risk level. The first risk level is lower than the second risk level, and the second risk level is lower than the third risk level.

In some embodiments, the low risk level and the medium risk level may be used as the first risk level, and the high risk level may be used as the second risk level.

In some embodiments, the fault levels may be further classified into fewer or more levels. This is not limited in embodiments of this application.

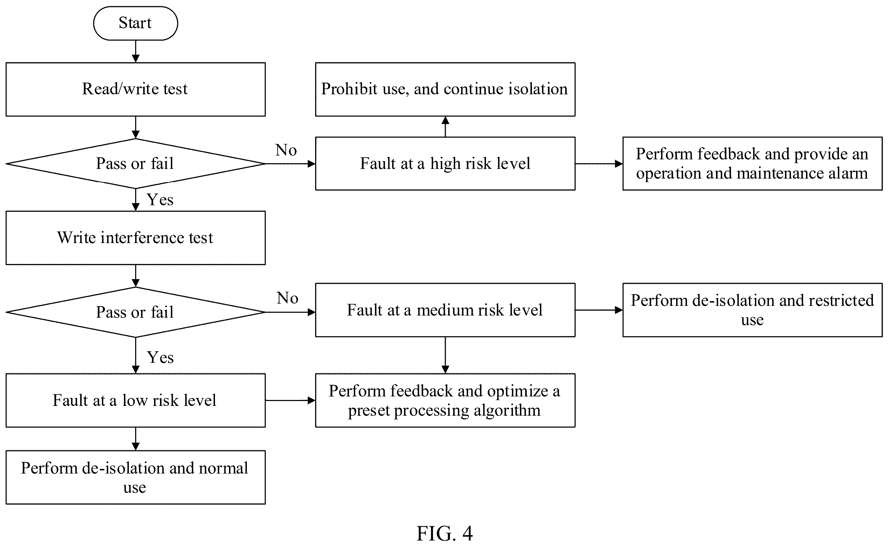

FIG. 4 shows an example of a process in which the fault level management module performs a pressure test on the faulty storage cell, and performs a corresponding operation on the storage cell based on a pressure test result. For details, refer to the descriptions in S207 and S208.

In this embodiment of this application, the faulty storage cell may be first isolated based on the memory fault information reported by the processor, to avoid access to incorrect data in the storage cell. In addition, the operating system may further perform a pressure test on the faulty storage cell, to obtain a fault level of the faulty storage cell. The operating system may perform different operations for storage cells at different fault levels. For example, for medium-risk and low-risk storage cells, a fault occurs due to a soft failure. The operating system may de-isolate these storage cells. These storage cells may continue to store data, and available storage cells in the electronic device may be added. However, to prevent a medium-risk storage cell from evolving into a high-risk storage cell, the medium-risk storage cell may be used to store insensitive data. In this embodiment of this application, different operations may be performed on faulty storage cells at different fault levels. This not only can increase available storage cells, but also can improve memory management flexibility.

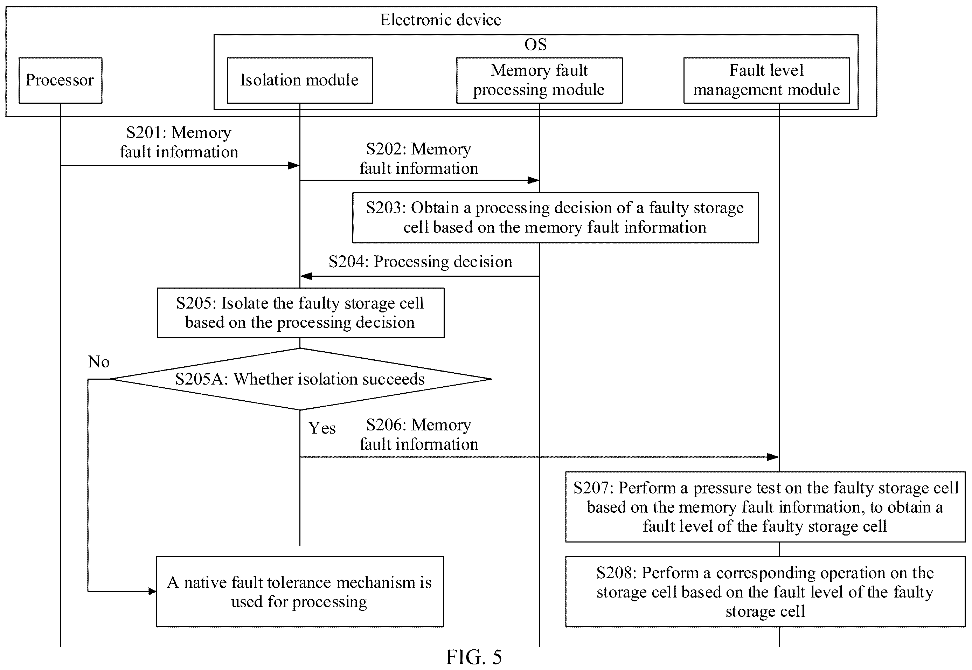

In some embodiments, as shown in FIG. 5, S205A may be further performed after S205.

S205A: The isolation module detects whether the faulty storage cell is successfully isolated. If the faulty storage cell is successfully isolated, S207 and S208 continue to be performed. If the faulty storage cell fails to be isolated, a native fault tolerance mechanism is used for processing.

In some embodiments, whether the faulty storage cell is successfully isolated may be detected based on whether the faulty storage cell can still be accessed. It should be noted that, when the faulty storage cell is successfully isolated, the fault level management module may continue to perform a pressure test on the faulty storage cell. When the faulty storage cell fails to be isolated, to avoid access to incorrect data in the storage cell, the native fault tolerance mechanism may be used for processing.

In some embodiments, the native fault tolerance mechanism may be, for example, reisolating the faulty storage cell until the isolation succeeds, or isolating the storage cell after a process that uses the storage cell is terminated. The native fault tolerance mechanism is not described in detail in this embodiment of this application. For details, refer to a current fault tolerance mechanism of isolating the storage cell by an operating system.

In this embodiment of this application, whether the faulty storage cell is successfully isolated may be further detected, so that isolation accuracy can be improved, avoiding access to incorrect data.

In some embodiments, based on the preset processing algorithm preset in the memory fault processing module, the memory fault processing module may not only obtain a processing decision of the faulty storage cell, but also predict, based on the memory fault information, a storage cell that is possibly faulty without memory fault information being reported currently. In this way, the operating system may isolate the predicted storage cell in advance, to avoid access to incorrect data in these storage cells, and to improve isolation accuracy.

In some embodiments, the processing decision of the faulty storage cell may further include an address of the predicted faulty storage cell, an isolation manner, and a secure address.

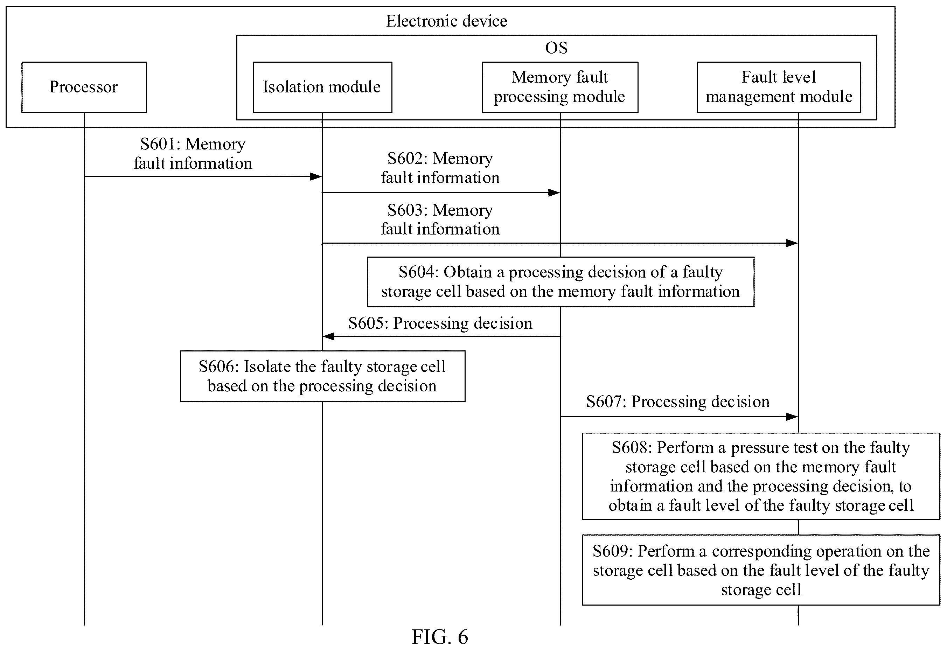

Refer to FIG. 6. A memory fault processing method provided in this embodiment of this application may include the following steps.

S601: A processor reports memory fault information to an isolation module.

S602: The isolation module sends the memory fault information to a memory fault processing module.

S603: The isolation module sends the memory fault information to a fault level management module.

There is no sequence difference between S602 and S603, and S602 and S603 may be performed simultaneously.

S604: The memory fault processing module obtains a processing decision of a faulty storage cell based on the memory fault information.

In some embodiments, the processing decision of the faulty storage cell may include: an address of the faulty storage cell indicated by the memory fault information, an isolation manner, and a secure address; and an address of the faulty storage cell predicted based on the memory fault information, an isolation manner, and a secure address. The faulty storage cell indicated by the memory fault information may be understood as a faulty storage cell included in the memory fault information, and the faulty storage cell predicted based on the memory fault information may be understood as a faulty storage cell predicted based on the memory fault information according to a preset processing algorithm.

In some embodiments, the faulty storage cell indicated by the memory fault information may be referred to as a first storage cell, and the faulty storage cell predicted based on the memory fault information may be referred to as a second storage cell.

S605: The memory fault processing module sends the processing decision to the isolation module.

S606: The isolation module isolates the faulty storage cell based on the processing decision.

S607: The memory fault processing module sends a processing decision to the fault level management module.

There is no sequence difference between S605 and S607, and S605 and S607 may be performed simultaneously.

For S601 to S606, refer to the descriptions in S201 to S206.

S608: The fault level management module performs a pressure test on the faulty storage cell based on the memory fault information and the processing decision, to obtain a fault level of the faulty storage cell.

Different from S207, in this embodiment of this application, the memory fault processing module may predict the faulty storage cell according to the preset processing algorithm. Therefore, in S608, the fault level management module not only needs to perform a pressure test on the faulty storage cell indicated by the memory fault information, a pressure test further needs to be performed on the predicted faulty storage cell. For a specific pressure test manner, refer to the descriptions in S207.

S609: The fault level management module performs a corresponding operation on the storage cell based on the fault level of the faulty storage cell.

For S609, refer to the descriptions in S208.

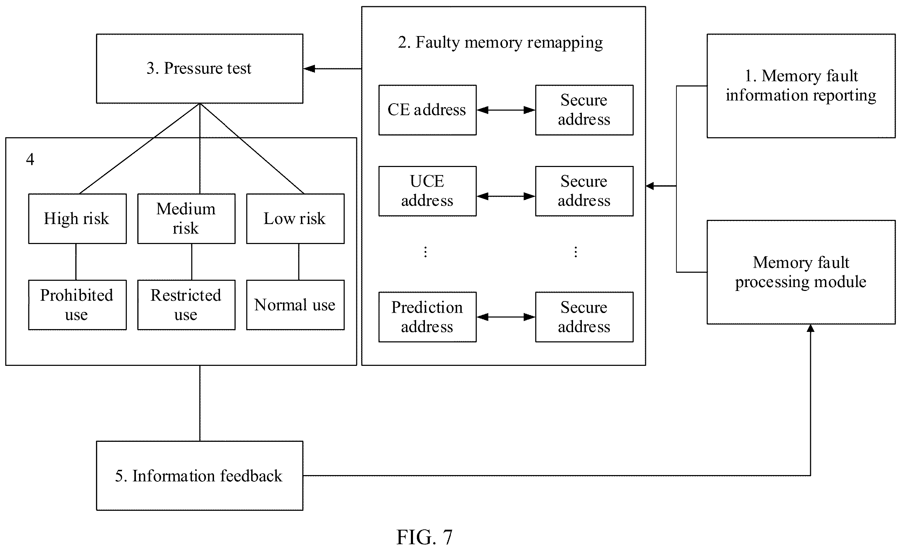

FIG. 7 is a schematic flowchart of processing memory fault information according to an embodiment of this application. Refer to FIG. 7. A memory fault processing method provided in this embodiment of this application may include the following steps.

Step 1: Memory fault information reporting.

Memory fault information reporting may include: A processor reports the memory fault information to an operating system (for example, an isolation module in the operating system), and the isolation module reports the memory fault information to a memory fault processing module and a fault level management module.

Step 2: Faulty memory remapping.

In this embodiment of this application, the memory fault processing module may obtain a processing decision of a faulty storage cell based on the memory fault information. In some embodiments, the processing decision may include an address of the faulty storage cell indicated by the memory fault information and a secure address, and an address of the faulty storage cell predicted based on the memory fault information and a secure address. For example, refer to FIG. 7, a CE address and a UCE address may be considered as an address of a faulty storage cell indicated by the memory fault information, and a prediction address may be considered as an address of a faulty storage cell predicted based on the memory fault information.

Step 3: Pressure test.

For the pressure test, refer to the descriptions in S207.

Step 4: Process the faulty storage cell based on a fault level.

For example, a storage cell at a high risk level may continue to be isolated, and a storage cell at a medium risk level and a storage cell at a low risk level may be de-isolated. The storage cell at the medium risk level may be restricted for use, and the storage cell at the low risk level may be restored to normal use.

Step 5: Information feedback.

For example, information feedback may include: The fault level management module feeds back the storage cell at the high risk level to the memory fault processing module, so that the memory fault processing module can perform processing such as an operation and maintenance alarm. For example, information feedback may include: The fault level management module may feed back the storage cell at the medium risk level and the storage cell at the low risk level to the memory fault processing module, so that the memory fault processing module can optimize a preset processing algorithm. For an information feedback manner, refer to the descriptions in S208.

In this embodiment of this application, when the memory fault processing module can predict the faulty storage cell based on the memory fault information, the fault level management module may further perform a pressure test on the faulty storage cell based on the processing decision and the memory fault information, so that a fault level of the faulty storage cell can be detected more completely, and the faulty storage cell can be accurately processed.

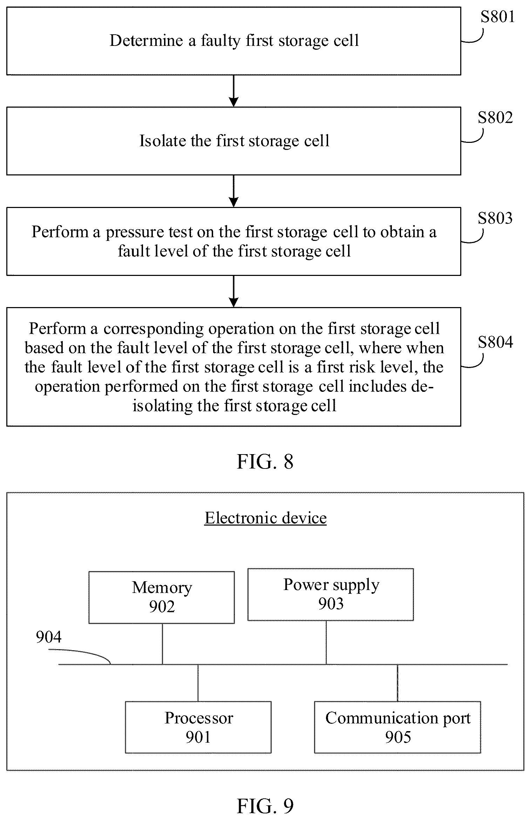

For example, an electronic device is used as an execution body. In some embodiments, refer to FIG. 8. A memory fault processing method provided in this embodiment of this application may include the following steps.

S801: Determine a faulty first storage cell.

In this embodiment of this application, a processor or a memory controller in an electronic device may detect memory, to determine the faulty first storage cell.

S802: Isolate the first storage cell.

In some embodiments, the electronic device may obtain a processing decision of the first storage cell based on memory fault information according to a preset processing algorithm, and further isolate the first storage cell based on the processing decision. For details, refer to the descriptions in S203 to S205.

S803: Perform a pressure test on the first storage cell to obtain a fault level of the first storage cell.

For S803, refer to the descriptions in S207.

S804: Perform a corresponding operation on the first storage cell based on the fault level of the first storage cell, where when the fault level of the first storage cell is a first risk level, the operation performed on the first storage cell includes de-isolating the first storage cell.

In some embodiments, the first risk level may include a low risk level. In some embodiments, the first risk level may include the low risk level and a medium risk level.

In some embodiments, the first risk level may indicate that a fault mode of the storage cell is a soft failure.

For S804, refer to the descriptions in S208.

A principle and technical effect of the memory fault processing method provided in this embodiment of this application are the same as those in the foregoing embodiments. For details, refer to the descriptions in the foregoing embodiments. Details are not described herein again.

It should be noted that data (including but not limited to data used for analysis, stored data, displayed data, and the like) in this application are information and data that are authorized by a user or fully authorized by all parties. In addition, collection, use, and processing of related data need to comply with related laws, regulations, and standards of related countries and regions, and a corresponding operation entry is provided for the user to choose to authorize or reject.

In an embodiment, an embodiment of this application further provides an electronic device. Refer to FIG. 9. The electronic device may include a processor 901 (for example, a CPU) and a memory 902. The memory 902 may include a high-speed random-access memory (random-access memory, RAM), and may further include a non-volatile memory (non-volatile memory, NVM), for example, at least one magnetic disk memory. The memory 902 may store various instructions, to complete various processing functions and implement the steps of the methods in this application.

Optionally, the electronic device in this application may further include a power supply 903, a communication bus 904, and a communication port 905. The communication port 905 is configured to implement connection and communication between the electronic device and another peripheral device. In this embodiment of this application, the memory 902 is configured to store computer-executable program code. The program code includes instructions. When the processor 901 executes the instructions, the instructions enable the processor 901 of the electronic device to perform the actions in the foregoing method embodiments. Implementation principles and technical effect thereof are similar to those in the foregoing method embodiments. Details are not described herein again.

It should be noted that the modules or components in the foregoing embodiments may be configured as one or more integrated circuits for implementing the foregoing methods, for example, one or more application-specific integrated circuits (application-specific integrated circuit, ASIC), one or more microprocessors (digital signal processor, DSP), or one or more field programmable gate arrays (field programmable gate array, FPGA). For another example, when one of the foregoing modules is implemented in a form of invoking program code by a processing element, the processing element may be a general-purpose processor, for example, a central processing unit (central processing unit, CPU) or another processor that can invoke the program code, for example, a controller. For another example, the modules may be integrated and implemented in a form of a system-on-a-chip (system-on-a-chip, SOC).

All or some of the foregoing embodiments may be implemented by using software, hardware, firmware, or any combination thereof. When software is used to implement the embodiments, all or a part of the embodiments may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state disk Solid-State Disk (SSD)), or the like.

The term "a plurality of" in this specification means two or more. The term "and/or" in this specification describes only an association relationship for describing associated objects and represents that three relationships may exist. For example, A and/or B may represent the following three cases: Only A exists, both A and B exist, and only B exists. In addition, a character "/" in this specification usually indicates an "or" relationship between associated objects, and a character "/" in a formula usually indicates a "divisible" relationship between associated objects. In addition, it should be understood that in description of this application, terms such as "first" and "second" are merely used for distinguishing and description, but should not be understood as indicating or implying relative importance, or should not be understood as indicating or implying a sequence.

It may be understood that various numbers in embodiments of this application are merely used for differentiation for ease of description, and are not used to limit the scope of embodiments of this application.

It should be understood that sequence numbers of the foregoing processes do not mean execution sequences in embodiments of this application. The execution sequences of the processes should be determined according to functions and internal logic of the processes, and should not be construed as any limitation on the implementation processes of embodiments of this application.

## Claims

1. A memory fault processing method, applied to an electronic device, wherein the method comprises:
determining a faulty first storage cell;
isolating the first storage cell;
performing a pressure test on the first storage cell to obtain a fault level of the first storage cell; and
performing a corresponding operation on the first storage cell based on the fault level of the first storage cell, wherein when the fault level of the first storage cell is a first risk level, the operation comprises de-isolating the first storage cell.

2. The method according to claim 1, wherein the fault level of the first storage cell further comprises a second risk level, and the first risk level is lower than the second risk level; and
when the fault level is the second risk level, performing the corresponding operation on the first storage cell comprises:
de-isolating the first storage cell, and establishing a memory pool, wherein the memory pool is configured to manage the first storage cell, and the first storage cell is configured to store data backed up by an external storage.

3. The method according to claim 2, wherein when the fault level is a third risk level, the operation is continuing to isolate the first storage cell, and the second risk level is lower than the third risk level.

4. The method according to any one of claims 1 to 3, wherein the pressure test comprises at least one of the following: a read/write test in at least one mode and a write interference test in at least one mode.

5. The method according to claim 4, wherein there is at least one first storage cell, and the pressure test comprises the read/write test in the at least one mode; and performing the pressure test on the first storage cell comprises:
step A: write preset data into the at least one first storage cell;
step B: sequentially read the data from the at least one first storage cell in a sequence from a low address to a high address based on an address of the at least one first storage cell, and check the data in the first storage cell;
step C: when the check succeeds, write a complementary set of the preset data into the at least one first storage cell;
step D: sequentially read the data from the at least one first storage cell in a sequence from a low address to a high address based on the address of the at least one first storage cell, and check the data in the first storage cell;
step E: when the check succeeds, return to perform step A to step D, and perform step F after step A to step D are repeatedly performed for n times and all the checks succeed; and when any check fails, determine that the read/write test fails; or when the check fails, determine that the read/write test fails, wherein n is an integer greater than or equal to 1;
step F: write preset data into the at least one first storage cell;
step G: sequentially read the data from the at least one first storage cell in a sequence from a high address to a low address based on the address of the at least one first storage cell, and check the data in the first storage cell;
step H: when the check succeeds, write a complementary set of the preset data into the at least one first storage cell;
step I: sequentially read the data from the at least one first storage cell in a sequence from a high address to a low address based on the address of the at least one first storage cell, and check the data in the first storage cell; and
step J: when the check succeeds, return to perform step F to step I, and determine that the read/write test succeeds after step F to step I are repeatedly performed for m times and all the checks succeed; and when any check fails, determine that the read/write test fails; or when the check fails, determine that the read/write test fails, wherein m is an integer greater than or equal to 1.

6. The method according to claim 4 or 5, wherein there is at least one first storage cell, the pressure test comprises the write interference test, and performing the pressure test on the first storage cell comprises:
writing preset data into a storage cell near the at least one first storage cell, and recording data in the first storage cell and in an adjacent row and an adjacent column of the first storage cell;
reading the data from the first storage cell and from the adjacent row and the adjacent column of the first storage cell, and checking the data in the first storage cell and the adjacent row and the adjacent column of the first storage cell; and
when the check succeeds, determining that the write test succeeds; or when the check fails, determining that the write test fails.

7. The method according to claim 6, wherein when the pressure test comprises the read/write test and the write interference test, obtaining the fault level of the first storage cell comprises:
when the first storage cell passes the read/write test and the write interference test, determining that the fault level is the first risk level;
when the first storage cell passes the read/write test but fails to pass the write interference test, determining that the fault level is the second risk level; or
when the first storage cell fails to pass the read/write test and the write interference test, determining that the fault level is the third risk level, wherein the first risk level is lower than the second risk level, and the second risk level is lower than the third risk level.

8. The method according to any one of claims 1 to 7, wherein the method further comprises:
predicting a faulty second storage cell based on the first storage cell according to a preset processing algorithm;
isolating the second storage cell;
performing a pressure test on the second storage cell to obtain a fault level of the second storage cell; and
performing a corresponding operation on the second storage cell based on the fault level of the second storage cell.

9. The method according to claim 8, wherein isolating the first storage cell comprises:
isolating the first storage cell according to the preset processing algorithm.

10. The method according to claim 9, wherein the method further comprises:
optimizing the preset processing algorithm based on the fault level of the first storage cell and the fault level of the second storage cell.

11. A memory fault apparatus, comprising a module configured to perform the method according to any one of claims 1 to 10.

12. The memory fault apparatus according to claim 11, wherein the memory fault apparatus is an operating system in an electronic device.

13. An electronic device, comprising a processor and a memory, wherein
the memory stores computer instructions; and
the processor executes the computer instructions stored in the memory, to cause the processor to perform the method according to any one of claims 1 to 10.

14. A computer-readable storage medium, wherein the computer-readable storage medium stores a computer program or instructions, and when the computer program or the instructions are run, the method according to any one of claims 1 to 10 is implemented.
